# EUROPÄISCHE PATENTANMELDUNG

(11) **EP 1 136 585 A1**
(43) Veröffentlichungstag der Anmeldung: **26.09.2001**
(21) Anmeldenummer: 00106154.8
(22) Anmeldetag: 21.03.2000
(51) Int. Cl.: C23C 14/06

(54) **Hartstoffschicht mit selbstschmierenden Eigenschaften**

(71) Anmelder: Logotherm AG, 8117 Fällanden (CH)
(72) Erfinder: Grohmann, Fred R., 8953 Dietikon (CH)
(74) Vertreter: Troesch Scheidegger Werner AG

(57) **Zusammenfassung**

Um einer Hartstoffschicht (33) bessere Gleiteigenschaften bei gleichzeitig weitgehendst erhaltener Abriebfestigkeit zu verleihen, wird vorgeschlagen, in der Hartstoffschicht Dropplets (35) oder sogenannte Nano-Clusters (35) einzulagern, welche aus einem Material bestehen, welches eine geringere Härte aufweist als die Hartstoffschicht selbst. Der Anteil an weichem Material bzw. der sogenannten Dropplets beträgt maximal 10%, wobei vorzugsweise weiche Materialien verwendet werden, wie Aluminium, Zinn, Palladium oder andere weiche Metalle, welche in vorzugsweise nicht reagiertem Zustand in die Hartstoffschicht eingelagert werden.

## Beschreibung

Die vorliegende Erfindung betrifft eine Hartstoffschicht mit selbstschmierenden Eigenschaften gemäss dem Oberbegriff nach Anspruch 10 sowie ein Verfahren zu deren Herstellung.

Nach wie vor werden sehr grosse Mengen an Schmierstoffen im Rahmen unserer Technik-orientierten Wirtschaft eingesetzt, und es ist daher ein aus ökologischer Sicht weltweit naheliegendes Anliegen, diese Menge zu reduzieren. Der heutige Bedarf an Schmierstoffen wird auf ca. 800 Millionen Tonnen geschätzt und eine Reduktion auf 400 Millionen Tonnen ist anzustreben. Die Reduktion kommt vor allem der Umwelt zugute, da die gebrauchten Schmierstoffe alle gereinigt, gefiltert und entsorgt werden müssen.

Als Lösung bieten sich sogenannte Hartstoffschichten an, welche gute Abriebeigenschaften sowie einen gewissen Selbstschmiereffekt aufweisen, oder Hartstoffschichten, welche mit einem selbstschmierenden Ueberzug beschichtet werden.

Mit grossem Erfolg werden heute Hartstoffschichten, wie beispielsweise aus Metallnitriden oder -carbiden mit einer MoS₂-Auflage versehen. Das Aufbringen, von MoS₂ auf Hartstoffschichten bedingt spezielle Anlagen in denen nur solche Schichten aufgebracht werden, denn es ist nicht möglich, z.B. MoS₂-Beschichtungen zu applizieren und direkt anschliessend in der gleichen Produktions-Anlage andere Beschichtungsprozesse (z.B. für das Erzeugen von Dekorschichten) durchzuführen.

Zudem haben MoS₂-Schichten den Nachteil, dass sie nicht sehr hart sind (ca. 1200 HV (Vickers-Härte)) und auf der Hartstoffschicht sehr dünn aufgetragen werden müssen (ca. 0,5µm). Wenn nun diese MoS₂-Schicht im täglichen Gebrauch in der Anwendung eines Werkstückes stark beansprucht wird, so kann sich diese MoS₂-Schicht relativ schnell abnützen, und es verbleibt schlussendlich eine "normale" Hartstoffschicht mit verminderten Gleiteigenschaften.

Aufgrund dieser Ausgangslage wäre es deshalb sicher sinnvoller, wenn auf eine zusätzliche Beschichtung der Hartstoffschicht verzichtet werden könnte, und die Hartstoffschicht selbst über verbesserte, selbstschmierende Eigenschaften verfügen würde. Oder aber der Ueberzug sollte über eine wesentlich verbesserte Abriebfestigkeit bei nach wie vor guten Gleiteigenschaften verfügen.

Es ist daher eine Aufgabe der vorliegenden Erfindung, eine Hartstoffschicht vorzuschlagen mit guter Abriebfestigkeit und mit guten Gleiteigenschaften bzw. mit selbstschmierenden Eigenschaften.

Erfindungsgemäss wird die gestellte Aufgabe mittels einer Hartstoffschicht mit selbstschmierenden Eigenschaften nach Anspruch 1 sowie mittels eines Verfahrens zu deren Herstellung nach Anspruch 11 gelöst.

Vorgeschlagen wird eine Hartstoffschicht, in welche sogenannte "weiche Teile" eingelagert sind, um der Hartstoffschicht die selbstschmierenden Eigenschaften zu verleihen.

Gemäss einer bevorzugten Ausführungsvariante wird vorgeschlagen, dass in einer beispielsweise mittels eines PVD-Verfahrens (Physical Vapour Deposition) erzeugten Hartstoffschicht, im wesentlichen bestehend aus Metallnitriden, -carbiden und/oder - carbonitriden, feinste Dropplets oder auch genannt Nano-Clusters eingelagert sind, welche aus einem Material bestehen, das eine geringere Härte aufweist als das Material, welches die Hartstoffschicht bildet.

Beim Material mit reduzierter Härte bzw. beim weichen, in Form von Dropplets eingebautem Material handelt es sich vorzugsweise um ein weiches Metall, welches vorzugsweise in Form von feinen Folien bzw. dünnen Blechen herstellbar ist, wie insbesondere um Aluminium, Zinn und dgl. Dabei reagiert dieses Material vorzugsweise nicht, d.h. es ist im metallischen nicht reagierten Zustand in das Hartstoffmaterial eingelagert.

Der Anteil an "weichem" Material beträgt beispielsweise 2 - 8%, vorzugsweise 3 - 5%, und die Dropplets bzw. winzigen Tröpfchen oder Nano-Clusters weisen einen Durchmesser von beispielsweise ca. 1 - 6, vorzugsweise 2 - 4 nm auf.

Bevorzugte Ausführungsvarianten der erfindungsgemäss vorgeschlagenen Hartstoffschicht mit selbstschmierenden Eigenschaften sind in den abhängigen Ansprüchen charakterisiert.

Der eigentliche Beschichtungsprozess zur Herstellung der Hartstoffschicht erfolgt beispielsweise mit einem PVD-Lichtbogenverfahren, wobei als Target reine Metalle oder Metalllegierungen verwendet werden, wie beispielsweise Titan, Zirkonium, Chrom, Vanadium, Hafnium und weitere, üblicherweise für die Herstellung von Hartstoffschichten verwendete Uebergangsmetalle. Gearbeitet wird beispielsweise im Hochvakuum mit Anteilen an Stickstoff und/oder Azetylen, wodurch in der Hartstoffschicht Nitride, Carbonitride oder Carbide der obengenannten Metalle abgeschieden werden.

Wie bereits oben erwähnt, erfolgt die Herstellung der Hartstoffschicht vorzugsweise mittels sogenanntem PVD - Physical Vapour Deposition - Verfahren, wobei dies generell unter Verwendung einer Plasma-erzeugenden Vorrichtung erfolgen kann, wie beispielsweise dem genannten Lichtbogen oder auch mittels Elektronenstrahlkanone. Dabei ist es vorteilhaft, wenn die zu beschichtenden Teile bzw. Substrate eine gewisse Temperatur haben, wie beispielsweise ca. 200°C, um so eine bessere Haftung auf der Oberfläche zu erzeugen. Allerdings ist die beim Substrat bzw. zu beschichtenden Teil einzustellende Anfangstemperatur vom Material des zu beschichtenden Teiles abhängig, und kann somit variieren bzw. vom obengenannten Wert abweichen.

Die Anfangstemperatur kann in der Anlage, beispielsweise mittels einer elektrischen Infrarotheizung, gesteuert werden, wobei dies in der Regel in einem Bereich von ca. 80° bis ca. 500°C möglich ist.

Ausgegangen wird von einem Anfangsvakuum von < 10⁻⁵ mbar, vorzugsweise von einem Vakuum von ca. 2,0 x 10⁻⁶ - 5,0 x 10⁻⁶ mbar. Bei der anschliessenden Beschichtung des Substrates wird das Vakuum durch Einlassen von Stickstoff oder Azetylen reduziert und pendelt sich in der Regel in einem Wertebereich von ca. 10⁻² bis 10⁻³ mbar ein. Dabei kann von reinem Stickstoff, von reinem Azetylen oder einem Gemisch von Stickstoff und Azetylen ausgegangen werden, wobei entsprechend Metallnitride, -carbide und/oder -carbonitride abgeschieden werden.

Gemäss einer bevorzugten Ausführungsvariante des erfindungsgemässen Verfahrens wird die Zusammensetzung des Gases während der Beschichtung verändert, so dass sich auch die Zusammensetzung in der Beschichtung während dem Beschichtungsvorgang ändert. Gemäss bevorzugter Ausführung erfolgt die Beschichtung in der Regel ausgehend von einer Stickstoffatmosphäre, wodurch anfänglich Nitride ausgeschieden werden. Zum Stickstoff wird nun Kohlenstoff in Form von Azetylen eingelassen, wodurch zunehmend Carbonitride in der Schicht mitabgeschieden werden. Der Kohlenstoffanteil verläuft vorzugsweise linear zunehmend, d.h. Azetylengas wird von einer anfänglichen Konzentration in der Grössenordnung von ca. 0 - 1% auf ca. 30 - 35% angehoben, womit entsprechend der Anteil Carbonitride in der Beschichtung zunimmt.

Für das Einbauen der erfindungsgemäss definierten Weichmaterial-Dropplets wird der Beschichtungsprozess bzw. das Coating unterbrochen zur Durchführung eines sogenannten Ion Etching-Prozesses. Währenddem beim Beschichtungsprozess das Substrat bzw. das zu beschichtende Teil mit einer Bias-Spannung im Bereich von ca. 20 - 45 Volt gehalten ist, wird während dem sogenannten Ion Etching-Prozess eine Bias-Spannung von über 1000 Volt angelegt. Das sogenannte Ion Etching oder Aetzen durch Ionen-Bombardierung erfolgt in der Regel in einer Argon-Atmosphäre, und durch die hohe Energie beim Ion Etching werden nun kleinste Metallteile aus einer Metallfolie herausgelöst, welche im Reaktionsraum bzw. der Vakuumkammer angeordnet ist. Diese herausgelösten Metallpartikel werden in der Hartstoffschicht eingelagert, wobei die Höhe des Metallanteils, wie beispielsweise des Aluminiumanteils, von der Dauer des Ion Etchings, wie auch von der Bias-Stromstärke kontrolliert bzw. eingestellt wird.

Dieses Ion Etching, welches früher auch "sputter cleaning" genannt worden ist, führt weiter dazu, dass die Oberfläche des zu beschichtenden Teils bzw. der obersten Schicht im Nanobereich aufgerauht, also gereinigt wird, wie ein "Sandstrahlen", jedoch mittels Ionen-Bombardierung, wodurch in der Oberfläche vorhandene Pin-holes, welche in der Regel verursacht durch Verunreinigungen in der Oberfläche des zu beschichtenden Teils bzw. der obersten Schicht vorhanden sind, beseitigt werden können; bzw. die vorhandenen Pin-holes oder Kleinstlöcher werden beim nachfolgenden weiteren Beschichtungsvorgang zugedeckt.

Die für das Herauslösen der Metallteile verwendeten Metallfolien müssen über eine hohe Reinheit verfügen, und müssen frei sein von irgendwelchen Verunreinigungen, wie beispielsweise sogenanntem "Ziehfett". Die Folie selbst weist eine Dicke in der Grössenordnung von ca. 0,05 - 0,4 mm auf. Vorzugsweise wird eine Aluminiumfolie verwendet, aus welcher Aluminium-Dropplets herausgelöst werden, um in der Schicht eingelagert zu werden. Nach Beendigung des sogenannten Ion Etching-Prozesses erfolgt erneut ein weiterer Beschichtungsprozess, wiederum ausgehend von einer weitgehendst reinen Stickstoffatmosphäre, so dass zu Beginn wiederum bevorzugt Metallnitride abgeschieden werden. Durch Zunahme des Azetylengehaltes erhöht sich erneut der Anteil Carbonitride bzw. Carbide in der Beschichtung.

Nach einer gewissen Dauer bzw. einer erneuten Schichtdicke von ca. 0,2 - 1,0 µ wird der Beschichtungsprozess erneut unterbrochen für die Durchführung eines weiteren Ion Etching-Prozesses für das Einlagern weiterer Metall-Dropplets.

Bevorzugte Ausführungsvarianten des erfindungsgemässen Verfahrens sind in den abhängigen Ansprüchen 11 bis 17 charakterisiert.

Die Erfindung wird nun beispielsweise anhand eines Ausführungsbeispieles und anhand der nachfolgend beschriebenen Figuren näher erläutert.

### Beispiel eines Beschichtungsprozesses zur Erzeugung einer Hartstoffschicht mit selbstschmierenden Eigenschaften:

Die nachfolgend angeführten Arbeits- bzw. Prozessbedingungen beziehen sich auf die beim Durchführen des Beispieles verwendete Anlage vom Typ Hauzer 1000-6.

### Vorstufe:

Die zu beschichtenden Teile bzw. Substrate werden gereinigt in den Rezipienten bzw. Reaktionsofen eingebracht.

Vor Beginn des Beschichtungsprozesses wird der Reaktionsraum evakuiert auf ein Vakuum von ca. 1,0 - 5,0 x 10⁻⁶ bar und das Substrat aufgeheizt auf eine Temperatur von ca. 150 - 350°C. Die Dauer bis zum Beginn des Prozesses kann bis zu ca. 2 - 3 Stunden betragen.

### Sputter cleaning (Ion Etching)-Phase:

Vor Beginn der Beschichtung kann die zu beschichtende Oberfläche zunächst mittels sogenanntem Ion Etching gereinigt werden. Dabei können beispielsweise folgende Prozessparameter eingestellt werden:
Bias: 1000 - 1400 Volt
Verdampfer: Einzeln bei ca. 60 - 110 Ah

Die Dauer des Stromflusses (Laufzeit) beim Sputter cleaning kann beispielsweise ca. 2 - 10 sek. betragen und die daran anschliessende Wartezeit beträgt ca. 30 sek bis 2 min.

Während der Dauer des Reinigungsprozesses bzw. des sogenannten Ion Etchings läuft eine Turbomolekularpumpe auf voller Leistung, um allfällig beim Reinigen entstehende Verunreinigungen sofort aus dem Bearbeitungsraum entfernen zu können. Zusätzlich wird der Sputter-cleaning-Prozess durch die Zugabe kleinster Mengen von Argon unterstützt.

### Coating-Phase:

Bei Beginn der Coating-Phase wird ein Bias am Substrat angelegt von anfänglich ca. 45 Volt, welches im Verlaufe der Coating-Phase bei steigendem Azetylenanteil auf einen Bereich von ca. 25 - 35 Volt reduziert wird. Der Verdampfer wird bei der Coating-Phase gepulst oder kontinuierlich betrieben, wobei bei fortschreitender Dauer der Coating-Phase die Stromstärke bei steigender Azetylenkonzentration reduziert wird.

Während der Coating-Phase wird ein weitgehendst konstanter Stickstofffluss in der Grössenordnung von ca. 30 - 60 ppm gewählt, währenddem der Azetylenfluss von ca. 0,5 - ca. 35 % steigend gewählt wird, was ca. 1 bis 25 - 30 ppm ergibt, wobei der Anstieg des Azetylenflusses vorzugsweise linear ansteigend eingestellt wird.

Der Druck im Rezipienten bzw. Reaktionsraum sollte im Bereich von ca. 5 x 10⁻³ - 1 x 10⁻² bar sein, und während dem gesamten Beschichtungsprozess läuft die obenerwähnte Turbomolekularpumpe lediglich mit einer Leistung von ca. 60 - 80 %.

Die totale Coating-Time beträgt ca. 10 - 20 min., womit sich ein totaler Coating-Stromfluss über die gesamte Dauer des Coating-Prozesses ergibt von ca. 150 - 200 Ah.

Das beschriebene Prozedere der beiden Phasen "Sputter cleaning" und "Coating" wird mehrmals abwechslungsweise wiederholt, wie beispielsweise 4 - 6 mal. Als Target können sowohl reine Metalle, wie beispielsweise Titan, Zirkonium, Vanadium, Niob, Chrom, Hafnium verwendet werden, oder Targets aus Metallen, welche üblicherweise für die Herstellung von Hartstoffschichten verwendet werden. Selbstverständlich können auch Legierungen dieser Metalle verwendet werden.

Für das Erzeugen der Weichmaterial-Dropplets wird vorzugsweise eine dünne Aluminium-Folie verwendet, welche im Rezipienten angeordnet wird, und aus welcher während dem Sputter-cleaning-Prozess kleinste Aluminium-Dropplets ausgelöst und in der Hartstoffschicht eingelagert werden.

Die nachfolgend beschriebenen Figuren zeigen:
- Fig. 1: im Schnitt, schematisch, eine PVD-Beschichtungsanlage mit einer im Rezipienten angeordneten, dünnen Metallfolie,
- Fig. 2: im Schnitt und schematisch, ein Beispiel eines erfindungsgemässen Schichtaufbaues, enthaltend die Weichmaterial-Dropplets, und
- Fig. 3: ein Diagramm, darstellend den Reibwert eines unbeschichteten Teiles, einer Hartstoffschicht sowie einer erfindungsgemäss hergestellten, selbstschmierenden Hartstoffschicht.

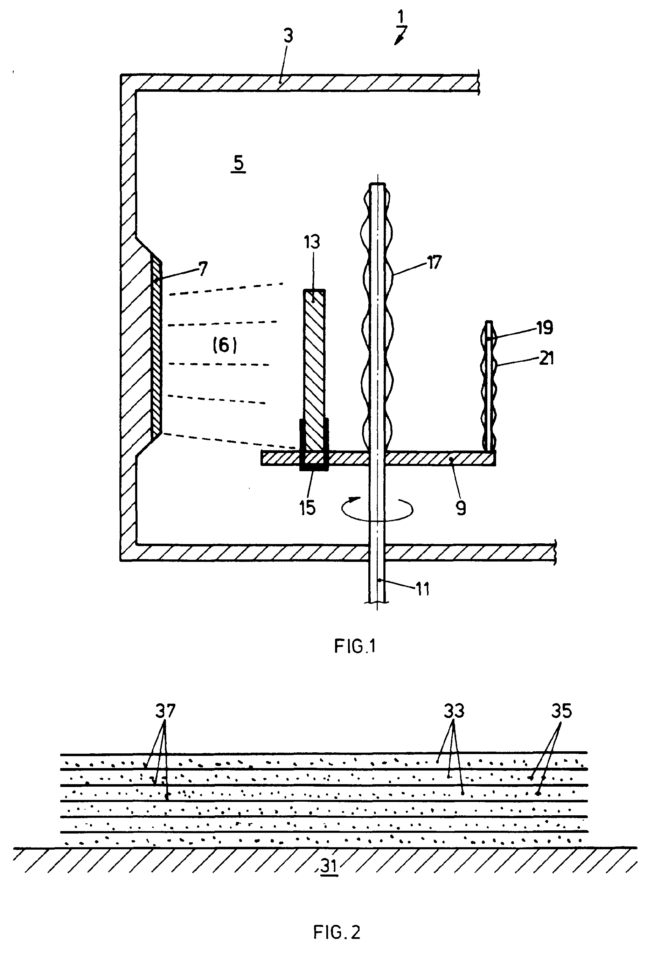

Figur 1 zeigt ausschnittsweise, schematisch, im Schnitt eine PVD-Anlage 1 mit der Reaktionskammer-Wandung 3 und dem im Reaktionsraum 5 angeordneten Target 7.

Mittels geeigneten Massnahmen, beispielsweise der Verwendung eines Lichtbogens oder einer anderen üblicherweise im PVD-Verfahren verwendeten Einrichtung, wird ein Plasma 6 erzeugt, aus welchem, je nach verwendetem Prozessgas, die entsprechenden Metallnitride, -carbonitride oder -carbide auf dem zu beschichtenden Substrat 13 abgeschieden werden. Das Substrat 13 ist beispielsweise in einem rotierenden Substrathalter 15 auf einem Aufnahmeteller bzw. Aufnahmesatelliten 9 gehalten. Der Aufnahmeteller 9 ist um einen Mittelstab 11 bzw. eine Rotationsachse drehbar, um eine allseitig gleichmässige Beschichtung zu gewährleisten.

Die für das Herauslösen der Weichmetall-Materialteile verantwortliche Metallfolie 17, wie beispielsweise eine Aluminiumfolie, kann nun um den Mittelstab 11 des Aufnahmetellers angeordnet werden, wie in Fig. 1 schematisch dargestellt.

Allerdings ist es auch möglich, eine Metallfolie 21 auf einem zusätzlichen Halterungsstab 19 anzuordnen, wie ebenfalls in Fig. 1 schematisch dargestellt.

Selbstverständlich handelt es sich in der in Fig. 1 dargestellten Anordnung lediglich um ein Beispiel zur Erläuterung der erfinderischen Idee. Selbstverständlich ist es auch möglich die Folie an einer Kammerwandung bzw. auf dem Boden des Reaktionsraumes anzuordnen. Wiederum ist es auch möglich, die Folie an einer vom Aufnahmeteller unabhängigen Halterung anzuordnen.

Fig. 2 zeigt im Schnitt und schematisch einen erfinderischen Schichtaufbau, wie beispielsweise erzeugt mittels den eingangs erwähnten Prozessbedingungen. Auf einem zu beschichtenden Substrat 31 werden mehrere Schichten 33 aufgetragen, beispielsweise abgeschieden mittels sogenanntem PVD-Verfahren. In diese Schichten eingelagert sind nicht reagierte Metall-Dropplets 35, welche eine wesentlich geringere Härte aufweisen als das Material, welches die Hartstoffschichten 33 bildet. So ist es beispielsweise möglich, dass das die Hartstoffschicht bildende Material eine Härte im Bereich von ca. 3000 - 4000 HV (Vickers Härte) aufweist, währenddem die Metall-Dropplets oder auch genannt Nano-Clusters eine Härte von ca. 150 - 200 HV aufweisen. Alu-Dropplets beispielsweise haben eine Härte von ca. 180 HV. Die Einlagerung der Weich-Dropplets erfolgt, wie oben erwähnt, bei den sogenannten Ion-Etching-Prozessstufen.

Durch die stufenweise Beschichtung ergeben sich sogenannte Ion Etching-Zwischengrenzschichten 37, bei welchen Grenzschichten jeweils die Zusammensetzung der Hartstoffschicht dann sprunghaft ändert, falls, wie oben erwähnt, jeweils der Anteil Carbonitride von zu beschichtender Unterlage bis zum jeweiligen Schichtende linear zunimmt. Selbstverständlich handelt es sich hierbei lediglich um ein Beispiel und es ist auch möglich, jeweils in den einzelnen Schichten gleichbleibende Zusammensetzungen der Hartstoffschicht zu wählen.

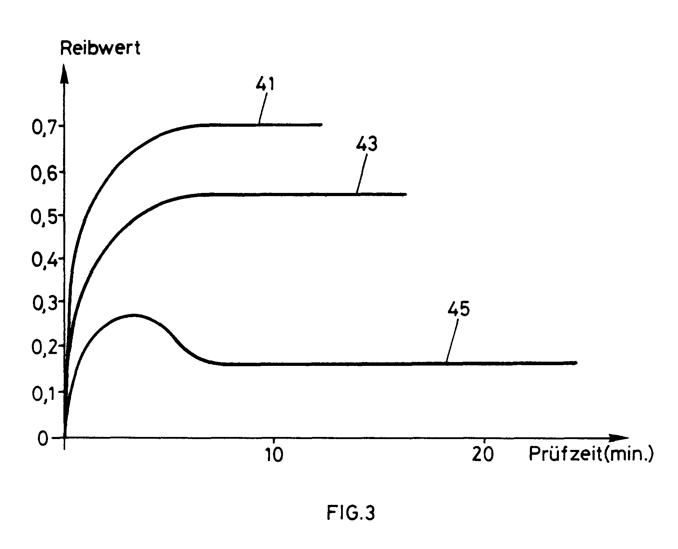

In Fig. 3 schlussendlich wird der Reibwert in Abhängigkeit der Gleitbelastung dargestellt. Dabei zeigt die Kurve 41 den Reibwert einer unbeschichteten Oberfläche, Kurve 43 den Reibwert einer mit einer konventionellen Hartstoffschicht versehenen Oberfläche, währenddem Kurve 45 den Reibwert einer erfindungsgemäss erzeugten selbstschmierenden Hartstoffschicht darstellt.

Daraus ist nun deutlich erkennbar, dass eine mit einer erfindungsgemäss erzeugten selbstschmierenden Hartstoffschicht versehene Oberfläche einen wesentlich verbesserten Trockenlauf ergibt als eine Oberfläche, versehen mit einer herkömmlichen Hartstoffschicht. Dadurch können bevorzugt Gleitelemente im Motorenbau, im Maschinenbau, in der Umformtechnik, im Formenbau, usw. mit der erfindungsgemäss erzeugten selbstschmierenden Hartstoffschicht versehen werden. Aber auch im Getriebebau kann die Verwendung der erfindungsgemässen Hartstoffschichten zu einem geringeren Schmierstoffverbrauch führen.

Durch die Verwendung der erfindungsgemäss definierten selbstschmierenden Hartstoffschicht wird somit ein entscheidender Beitrag an die Verminderung des Schmierstoffverbrauches geleistet, und somit stellt die vorliegende Erfindung einen Meilenstein in Richtung geringerer Umweltbelastung dar.

Selbstverständlich ist die vorliegende Erfindung nicht auf die beispielsweise erwähnten Hartstoffschichten, Herstellverfahren, usw. beschränkt, sondern die vorliegende Erfindung umfasst jegwelche Art von Hartstoffschichten, in welche sogenannte Weichmaterial-Dropplets eingebaut sind, zur Erhöhung der selbstschmierenden Eigenschaften der Hartstoffschichten.

## Patentansprüche

1. Hartstoff-Gleitschicht, **gekennzeichnet durch** in der Hartstoffschicht eingelagerte Dropplets oder sogenannte Nano-Clusters aus einem Material, welches eine geringere Härte aufweist als die Hartstoffschicht.

2. Gleitschicht, insbesondere nach Anspruch 1, **dadurch gekennzeichnet, dass** der Anteil an weichem Material bzw. der sogenannten Dropplets maximal 10%, ca. zwischen 2 - 8%, bevorzugt ca. 3 - 5%, bezogen auf die gesamte Hartstoffschicht, beträgt.

3. Gleitschicht, insbesondere nach Anspruch 1 oder 2, **dadurch gekennzeichnet, dass** die Hartstoffschicht im wesentlichen aus Nitriden, Carbiden und/oder Carbonitriden besteht.

4. Gleitschicht, insbesondere nach einem der Ansprüche 1 - 3, **dadurch gekennzeichnet, dass** die Hartstoffschicht im wesentlichen aus Metallnitriden, -carbiden und/oder -carbonitriden, wie Ti-, Cr-, Zr-, V-, Hf-, Nb-, sowie weiter üblicherweise verwendete Uebergangsmetall-Verbindungen besteht.

5. Gleitschicht, insbesondere nach einem der Ansprüche 1 - 4, **dadurch gekennzeichnet, dass** als weiches Material zur Bildung der Dropplets Aluminium, Zinn, Palladium und/oder ein anderes weiches Metall eingelagert ist, aus welchem vorzugsweise dünne Folien bzw. Bleche herstellbar sind.

6. Gleitschicht, insbesondere nach einem der Ansprüche 1 - 5, **dadurch gekennzeichnet, dass** sie aus mehreren, übereinanderliegenden Schichten gebildet wird, wobei das weiche Material bzw. die Dropplets im wesentlichen im Bereich je zwei aneinander stossender Schichten eingelagert ist.

7. Gleitschicht, insbesondere nach einem der Ansprüche 1 - 6, **dadurch gekennzeichnet, dass** die Dopplets einen Durchmesser von ca. 1 - 6, vorzugsweise 2 - 4 nm aufweisen.

8. Gleitschicht, insbesondere nach einem der Ansprüche 6 oder 7, **dadurch gekennzeichnet, dass** die einzelnen Schichten eine von der Substratoberfläche zur Gleitschichtoberfläche hin sich verändernde Zusammensetzung aufweisen, wobei der Anteil Metall-nitride von nahezu 95 - 100% jeweils auf einen Anteil von ca. 80 - 50% abnimmt und entsprechend der Anteil Metallcarbonitride und/oder Metallcarbid von jeweils ca. 0 - 5% auf ca. 20 - 50% zunimmt.

9. Gleitschicht, insbesondere nach einem der Ansprüche 6 - 8, **dadurch gekennzeichnet, dass** die Dicke der einzelnen Schichten ca. je 5 - 30, vorzugsweise 5 - 10 nm beträgt.

10. Gleitschicht, insbesondere nach einem der Ansprüche 1 - 9, **dadurch gekennzeichnet, dass** die Härte der Hartstoffschicht ca. 3000 - 4000 HV beträgt, währenddem die Härte der Weichmaterial-Dropplets ca. 150 - 300 HV beträgt.

11. Verfahren zur Herstellung einer Hartstoffgleitschicht mit selbstschmierenden Eigenschaften, **gekennzeichnet durch** ein PVD-Verfahren zur Herstellung der Beschichtung und dem Einlagern von sogenannten Weichmaterial-Dropplets, bestehend aus einem Werkstoff, welcher eine wesentlich kleinere Härte aufweist als die Hartstoffbeschichtung.

12. Verfahren, insbesondere nach Anspruch 11, **dadurch gekennzeichnet, dass** der Beschichtungsprozess mittels Lichtbogenverdampfung mindestens eines Metalles, ausgewählt aus Chrom, Titan, Zirkonium, Vanadium, Hafnium und/oder Niob ausgewählt wird, wobei die Beschichtung in einer Stickstoff- und/oder Azetylen-enthaltenden Atmosphäre zur Bildung der Hartstoffschicht erfolgt.

13. Verfahren, insbesondere nach einem der Ansprüche 11 oder 12, **dadurch gekennzeichnet, dass** beim Beschichtungsprozess eine Biasspannung von ca. 20 - 50 Volt verwendet wird.

14. Verfahren, insbesondere nach einem der Ansprüche 11 - 13, **dadurch gekennzeichnet, dass** für das Einlagern der Weichmaterial-Dropplets der Beschichtungsprozess jeweils unterbrochen wird, und mittels Ion Etching von einer im Reaktionsraum angeordneten Metallfolie Partikel herausgelöst und in der Beschichtung eingelagert werden.

15. Verfahren, insbesondere nach Anspruch 14, **dadurch gekennzeichnet, dass** beim Ion Etching eine Biasspannung von ca. 1000 - 1500 Volt verwendet wird.

16. Verfahren, insbesondere nach einem der Ansprüche 11 - 15,
**dadurch gekennzeichnet, dass** die Herstellung der Gleitschicht stufenweise erfolgt, indem die Beschichtung jeweils unterbrochen wird durch ein Ion Etching für das Einlagern der Metall-Dropplets, anschliessend die Beschichtung weiter erfolgt und erneut durch Ion Etching unterbrochen wird, usw.

17. Verfahren, insbesondere nach einem der Ansprüche 11 - 16, **dadurch gekennzeichnet, dass** bei jeder Beschichtungsstufe jeweils von einer weitgehendst Stickstoff-enthaltenden Atmosphäre ausgegangen wird, um weitgehendst Metall-Nitride abzuscheiden, und mit fortschreitender Beschichtungsdauer dem Prozessgas, vorzugsweise linear steigend, Azetylen beigemischt wird, um den Anteil Metallcarbide bzw. Metallcarbonitride in den jeweilig entstehenden Schichten zu erhöhen.
